# EUROPÄISCHE PATENTSCHRIFT

(11) **EP 2 639 943 B1**
(45) Veröffentlichungstag und Bekanntmachung des Hinweises auf die Patenterteilung: **25.02.2015**
(21) Anmeldenummer: 12159620.9
(22) Anmeldetag: 15.03.2012
(51) Int. Cl.: H02K 11/00, F04D 25/06, H05K 5/00

(54) **Elektromotor**
Electric motor
Moteur électrique

(43) Veröffentlichungstag der Anmeldung: 18.09.2013
(73) Patentinhaber: Grundfos Holding A/S, 8850 Bjerringbro (DK)
(72) Erfinder: Mønster, Peter, 8900 Randers C (DK); Østergaard, Lars, 8920 Randers NV (DK)
(74) Vertreter: Patentanwälte Vollmann & Hemmer

(56) Entgegenhaltungen:
- EP-A1- 1 947 343
- DE-A1-102008 033 859
- JP-A- 2000 133 104

## Beschreibung

Die Erfindung betrifft einen Elektromotor mit den im Oberbegriff des Anspruchs 1 angegebenen Merkmalen sowie ein Pumpenaggregat mit einem solchen Elektromotor

Elektromotoren weisen in der Regel ein Statorgehäuse und ein an dem Statorgehäuse angebrachtes Elektronikgehäuse auf. In dem Elektronikgehäuse sind elektronische Steuerelemente zur Steuerung bzw. zum Antrieb des Elektromotors angeordnet. Insbesondere kann in dem Elektronikgehäuse ein Frequenzumrichter angeordnet sein. Darüber hinaus weisen derartige Elektronikgehäuse in der Regel eine Bedieneinheit auf, an welcher erforderliche Einstellungen zur Bedienung des Elektromotors vorgenommen werden können und darüber hinaus Anzeigelemente vorgesehen sein können, um bestimmte Betriebszustände des Elektromotors anzuzeigen.

Solche Bedieneinheiten sind in der Regel so ausgerichtet, dass sie von einer bestimmten Seite des Elektromotors her optimal zu betrachten sind. Insbesondere mögliche Beschriftungen und Anzeigelemente sind so ausgerichtet, dass sie von einer bestimmten Seite her ablesbar sind. Dies ist von Nachteil, wenn der Elektromotor im Betrieb so aufgestellt werden muss, dass er von dieser bestimmten Seite nicht bedienbar bzw. einsehbar ist. Dann besteht das Problem, dass die Bedieneinheit möglicherweise nur verkehrt herum betrachtet werden kann.

EP 1 947 343 A1 offenbart ein Pumpenaggregat mit einem elektrischen Antriebsmotor, bei welchem am axialen Ende des Statorgehäuses ein Klemmenkasten angesetzt ist, an dessen stirnseitigen Deckel Bedien- und Anzeigeelemente angeordnet sind. Die Bedien- und Anzeigeelemente sind nur in einer definierten Einbaulage des Antriebsmotors in richtiger Ausrichtung ablesbar.

JP 2000133104 A offenbart eine Anzeigeeinrichtung einer Zeitschaltuhr, bei welcher auf einem Display zwei identische, in unterschiedlichen Ausrichtungen angeordnete Anzeigefelder ausgebildet sind, wobei das nicht genutzte Anzeigeelement durch einen aufgesetzten Deckel abgedeckt wird.

Es ist daher Aufgabe der Erfindung, einen Elektromotor mit einem Elektronikgehäuse dahingehend zu verbessern, dass die Bedieneinheit auf einfache Weise von unterschiedlichen Richtungen her ablesbar und bedienbar ist.

Diese Aufgabe wird gelöst durch einen Elektromotor mit den in Anspruch 1 angegebenen Merkmalen sowie durch ein Pumpenaggregat mit einem solchen Elektromotor gemäß Anspruch 16. Bevorzugte Ausführungsformen ergeben sich aus den Unteransprüchen, der nachfolgenden Beschreibung sowie den beigefügten Figuren.

Der erfindungsgemäße Elektromotor weist in bekannter Weise ein Elektronikgehäuse auf. In diesem Elektronikgehäuse können insbesondere Steuerelemente und andere elektronische Elemente und andere elektronische Bauteile zur Steuerung bzw. zum Betrieb des Elektromotors angeordnet sein. Besonders bevorzugt kann in dem Elektronikgehäuse auch ein Frequenzumrichter angeordnet sein. Das Elektronikgehäuse ist vorzugsweise an der Außenseite eines Statorgehäuses des Elektromotors befestigt. Ferner weist das Elektronikgehäuse einen abnehmbaren Deckel auf. Der Deckel kann beispielsweise abgenommen werden, um elektrische Anschlussleitungen im Inneren des Elektronikgehäuses anschließen zu können. Dies kann beispielsweise eine Netzanschlussleitung und/oder eine Anschlussleitung zur Verbindung mit externen Sensor- oder Steuerelementen sein. Der Deckel verschließt vorzugsweise das Elektronikgehäuse an einer dem Statorgehäuse abgewandten Oberseite. An dem Deckel ist darüber hinaus eine Bedieneinheit angeordnet, über welche Einstellungen von Betriebszuständen des Elektromotors vorgenommen werden können und welches darüber hinaus Anzeigelemente zum Anzeigen von Betriebszuständen des Elektromotors ausweist.

Erfindungsgemäß ist vorgesehen, dass die Bedieneinheit ein an dem Deckel befestigtes Bedienfeld aufweist. Das Bedienfeld ist dabei dasjenige Bauteil, welches von außen betrachtbar ist und an welchem eventuell vorhandene Bedienelemente wie Drucktaster und ähnliches angeordnet sind. Dieses Bedienfeld ist bevorzugt fest mit dem Deckel verbunden, sodass es gemeinsam mit dem Deckel von dem Elektronikgehäuse abgenommen werden kann. Erfindungsgemäß ist nun der Deckel mit dem Bedienfeld in zumindest zwei alternativen Ausrichtungen mit einem Unterteil des Elektronikgehäuses verbindbar. D. h. das Bedienfeld der Bedieneinheit kann auf einfache Weise unterschiedlich ausgerichtet werden, indem der Deckel in alternativen Ausrichtungen mit dem Unterteil des Elektronikgehäuses verbunden wird. Beispielsweise kann der Deckel in zwei um 90° oder 180° gedrehten Positionen mit dem Unterteil verbindbar, beispielsweise verschraubbar sein. So kann gemeinsam mit dem Deckel auch das Bedienfeld um 90° oder 180° gedreht werden. So kann je nach Einbaulage des Elektromotors das Bedienfeld mit dem Deckel an dem Unterteil des Elektronikgehäuses in derjenigen der alternativen Ausrichtungen befestigt werden, in welcher das Bedienfeld optimal einsehbar ist. Die feste Anordnung des Bedienfeldes an dem Deckel hat dabei den Vorteil, dass zur Ausrichtung des Bedienfeldes beim Aufstellen und der Montage des Elektromotors keine weiteren Montageschritte erforderlich sind, da der Deckel zum Anschluss elektrischer Anschlussleitungen ohnehin abgenommen werden muss und dann anschließend einfach in der gewünschten Ausrichtung wieder an dem Unterteil des Elektronikgehäuses befestigt werden kann.

Um eine Ausrichtung in zwei alternativen um 180° gedrehten Ausrichtungen zu ermöglichen, sind bevorzugt die mit dem Unterteil in Kontakt kommenden Schnittstellen des Deckels spiegelsymmetrisch zu einer Mittellinie bzw. Symmetrieachse des Deckels ausgebildet. Dies ermöglicht es den Deckel um 180° um eine Drehachse gedreht an dem Unterteil zu befestigen, wobei sich die Drehachse normal zu der Mittellinie des Deckels erstreckt und diese schneidet. Die mit dem Unterteil in Kontakt kommenden Schnittstellen sind die Anlageflächen bzw. Anlagekanten des Deckels, welche an korrespondierenden Anlageflächen bzw. - kanten des Unterteils zur Anlage kommen. Darüber hinaus sind dies die Befestigungselemente, wie beispielsweise Schrauben und korrespondierende Schraub- bzw. Gewindelöcher. Insbesondere sind diese Schrauben und Gewindelöcher so symmetrisch zueinander angeordnet, dass der Deckel in allen alternativen Ausrichtungen stets mit denselben Befestigungselementen an dem Unterteil befestigt werden kann. So sind für die unterschiedlichen Ausrichtungen keine zusätzlichen Befestigungselemente erforderlich. Bei Drehung des Deckels von einer ersten Ausrichtung in die zweite Ausrichtung greift dann beispielsweise eine Schraube nicht in ein erstes Gewindeloch ein, sondern in ein zweites gegenüberliegendes Gewindeloch und die Schraube, welche in der ersten Ausrichtung in das zweite gegenüberliegende Gewindeloch eingreifen würde, greift entsprechend in ein erstes Gewindeloch ein.

Gemäß einer weiteren bevorzugten Ausführungsform weist die Bedieneinheit neben dem Bedienfeld eine in dem Unterteil getrennt von dem Deckel angeordnete Elektronikeinheit auf, welche mit dem Bedienfeld zusammenwirkt. Die Elektronikeinheit ist nicht mit dem Deckel verbunden und beinhaltet vorzugsweise elektrische Anzeigelemente, wie beispielsweise ein Display oder LED, und Bedienelemente wie elektrische Schaltelemente oder Taster. Das Bedienfeld ist so ausgebildet, dass die Anzeigelemente, welche an der Elektronikeinheit angeordnet sind, durch das Bedienfeld hindurch sichtbar sind. Dazu können in dem Bedienfeld Fenster oder Lichtleiter vorgesehen sein. Ferner sind in dem Bedienfeld mechanische Bedienelemente vorgesehen, welche auf elektrische Schaltelemente in der Elektronikeinheit, beispielsweise elektrische Schalter oder Taster wirken. Eine Übertragung der Schaltfunktion kann dabei mechanisch berührend oder beispielsweise auch durch magnetische Kopplung erfolgen.

Besonders bevorzugt ist das Bedienfeld als rein mechanisches Bauteil ausgebildet, welches frei von elektrischen Bauteilen ist. Dies hat den Vorteil, dass das Bedienfeld von der Elektronikeinheit problemlos getrennt werden kann. So ist keinerlei Verbindung, insbesondere keine elektrische Verbindung zwischen dem Deckel und dem Unterteil und dem Elektronikgehäuse erforderlich, sodass der Deckel leicht vollständig abgenommen werden kann. Die Elektronikeinheit kann mit den übrigen elektronischen Bauteilen im Inneren des Klemmenkastens bzw. Elektronikgehäuses in dessen Unterteil verbleiben.

Dabei ist die Elektronikeinheit in dem Unterteil bevorzug in zumindest zwei zu den alternativen Ausrichtungen des Deckels korrespondierenden Ausrichtungen befestigbar. Dies ermöglicht es, dass wenn z. B. der Deckel in eine zweite alternative Ausrichtung gedreht wird, auch die Elektronikeinheit, welche unter dem Deckel zu liegen kommt, in dem Unterteil entsprechend in einer zweiten alternativen Ausrichtung ausgerichtet werden kann, sodass die Elektronikeinheit stets eine vorgegebene Ausrichtung relativ zu dem Bedienfeld, welches mit dem Deckel verbunden ist, behält, unabhängig davon in welcher der vorgesehenen mehreren alternativen Ausrichtungen der Deckel an dem Unterteil befestigt wird. Die Elektronikeinheit wird stets vor Befestigung des Deckels entsprechend in dem Unterteil ausgerichtet.

Die Elektronikeinheit kann dazu über zumindest ein Rastelement in dem Unterteil fixiert sein. Dies ermöglicht es, die Elektronikeinheit leicht lösen und in der gewünschten Ausrichtung bzw. Winkelposition in dem Unterteil zu fixieren zu können, ohne das hierfür spezielles Werkzeug erforderlich wäre. Alternativ oder zusätzlich kann die Elektronikeinheit in dem Unterteil beispielsweise auch durch Schrauben gesichert sein.

Das Bedienfeld ist weiter bevorzugt mit zumindest einem transparenten Fenster und die Elektronikeinheit mit zumindest einem unter diesem Fenster platzierten Anzeigeelement versehen. Ein solches Anzeigeelement kann ein Display, wie ein LED- oder LCD-Display oder ein Leuchtelement, wie eine LED sein. Bei dem Display kann es sich gegebenenfalls auch um ein berührungsempfindliches Display handeln, wobei dann das transparente Fenster des Bedienfeldes so ausgebildet ist, dass es die berührungsempfindliche Funktion eines darunter liegenden Displays nicht behindert oder gegebenenfalls unterstützt. Die transparenten Fenster können vollständig transparent oder teiltransparent sein. Darüber hinaus können die Fenster auch gefärbt sein und/oder Beschriftungen tragen, welche gegebenenfalls erst beim Einschalten eines Anzeigelementes sichtbar werden. Dies kann durch teiltransparente Ausgestaltung erreicht werden, welche sich von der Umgebung im ausgeschalteten Zustand des Anzeigeelementes nicht abhebt, sodass das Fenster nur im beleuchteten Zustand sichtbar ist.

Weiter bevorzugt weist das Bedienfeld zumindest einen elastisch verformbaren Druckbereich auf und die Elektronikeinheit weist zumindest ein unter diesem Druckbereich platziertes elektrisches Schaltelement auf. Durch Druck auf den Druckbereich kann dieser so verformt werden, dass der Druckbereich auf ein darunter liegendes elektrisches Schaltelement in der Elektronikeinheit wirkt, beispielsweise auf einen Schalter oder Taster an der Elektronikeinheit drückt. So wird eine rein mechanische Verbindung zwischen dem Druckbereich des Bedienfeldes und einem elektrischen Schaltelement in der Elektronikeinheit erreicht. Es sind somit keine elektrischen Verbindungen zu dem Bedienfeld für etwaige Bedienelemente, welche von außen bedienbar sein sollen, erforderlich. So kann das Bedienfeld mit dem Deckel leicht von der Elektronikeinheit trennbar ausgebildet werden.

Die Elektronikeinheit ist ihrerseits bevorzugt über zumindest eine Steck- und/oder Kabelverbindung elektrisch mit weiteren in dem Unterteil angeordneten elektrischen Bauteilen verbunden. Diese weiteren elektronischen Bauteile können insbesondere an einer Leiterplatte angeordnet sein, mit welcher die Elektronikeinheit über die Steck- oder Kabelverbindung verbunden ist. Die Steckverbindung kann so ausgebildet sein, dass sie in mehreren Winkelpositionen in Eingriff treten kann. Alternativ können mehrere Steckverbindungen ausgebildet sein, wobei die Elektronikeinheit dann je nach gewählter Ausrichtung mit einer dieser mehreren Steckverbindungen in dem Unterteil des Klemmenkastens elektrisch leitend in Eingriff tritt. Alternativ kann eine Kabelverbindung ausgebildet sein, welche eine Drehbarkeit bzw. Ausrichtbarkeit der Elektronikeinheit in unterschiedlichen Winkelpositionen bzw. Ausrichtungen ermöglicht. Dabei bewegt sich lediglich die Kabelverbindung zwischen der Elektronikeinheit und den weiteren elektronischen Bauteilen bzw. einer Leiterplatte.

Gemäß einer weiteren bevorzugten Ausführungsform wird die Elektronikeinheit über zumindest ein Federelement in Anlage an dem Bedienfeld und/oder in Anlage an einer Innenseite des Deckels gehalten. Dies ist von Vorteil, um die gewünschte Wechselwirkung des Bedienfeldes mit der Elektronikeinheit sicherstellen zu können. Dazu muss die Elektronikeinheit bevorzugt in einer definierten Position zu dem Bedienfeld gehalten werden, insbesondere ausreichend nah an dem Bedienfeld angeordnet sein, sodass beispielsweise verformbare Druckbereiche des Bedienfeldes auf elektrische Schaltelemente in der Elektronikeinheit wirken können und Anzeigelemente von außen durch Fenster in dem Bedienfeld sichtbar sind. Die Federelemente können dabei auftretende Toleranzen zwischen der Elektronikeinheit und dem Bedienfeld ausgleichen, welche beispielsweise auch aus der Befestigung des Deckels resultieren können. Insbesondere wenn zwischen Deckel und Unterteil eine Dichtung angeordnet ist, welche bei Befestigung des Deckels verformt wird, kann nicht sichergestellt werden, dass der Abstand zwischen Deckel und Unterteil stets genau definiert derselbe ist. Gewisse Abstandsschwankungen können dann durch das zumindest eine Federelement ausgeglichen werden, sodass die Elektronikeinheit stets in der gewünschten Anlage an dem Bedienfeld und/oder an der Innenseite des Deckels gehalten wird. Besonders bevorzugt sind mehrere Federelemente, insbesondere drei oder vier Federelemente vorhanden, um die Elektronikeinheit gleichmäßig mit Kraft zu beaufschlagen.

Das zumindest eine Federelement ist weiter bevorzugt an einer Abdeckung befestigt, welche im Inneren des Elektronikgehäuses angeordnet ist und im Unterteil angeordnete elektronische Bauteile zum Deckel hin abdeckt. Dabei ist die Abdeckung bevorzugt so angeordnet, dass elektrische Anschlusselemente bzw. Anschlussklemmen, welche benötigt werden, um Anschlussleitungen, wie beispielsweise eine Netzleitung und/oder Steuer- oder Datenleitungen, welche an das Elektronikgehäuse angeschlossen werden sollen, nicht abgedeckt sind. So wird durch die Abdeckung sichergestellt, dass beim Abnehmen des Deckels die elektronischen Bauteile in dem Elektronikgehäuse durch die Abdeckung geschützt bleiben und lediglich die erforderlichen Anschlusselemente nach Abnahme des Deckels frei zugänglich sind. Die Elektronikeinheit ist bevorzugt über die Federelemente an dieser Abdeckung befestigt, d. h. das zumindest eine Federelement ist vorzugsweise an der Abdeckung befestigt.

Die Elektronikeinheit kann ihrerseits wiederum in einer separaten Umhüllung oder einem separaten Gehäuse angeordnet sein, welches die elektronischen Bauteile der Elektronikeinheit schützt. So sind elektronische Bauteile der Elektronikeinheit insbesondere dann geschützt, wenn der Deckel von dem Unterteil des Elektronikgehäuses abgenommen ist. So können die elektronischen Bauteile der Elektronikeinheit nicht unbeabsichtigt, beispielsweise beim Anschließen von Anschlussleitungen im Inneren des Klemmenkastens beschädigt werden. Gegebenenfalls erforderliche elektrische Schaltelemente können in bekannter Weise in Öffnungen oder Ausnehmungen eines solchen Gehäuses der Elektronikeinheit angeordnet sein.

Besonders bevorzugt ist das zumindest eine Federelement ein Elastomerelement. Ein solches kann sehr einfach und kostengünstig gefertigt werden. Darüber hinaus kann das Elastomer-Element bevorzugt einstückig mit einer an der Abdeckung angeordneten Dichtung ausgebildet sein. Eine solche Dichtung kann zum einen die Abdeckung gegenüber den Gehäusewandungen des Unterteils des Elektronikgehäuses abdichten, sodass die elektronischen Bauteile unter der Abdeckung in einem abgedichteten Raum angeordnet sind. Darüber hinaus ist die Dichtung vorzugsweise dichtend mit dem Unterteil und dem Deckel in Anlage, wenn der Deckel auf das Unterteil aufgesetzt ist. D. h. die Dichtung erstreckt sich zwischen die Anlageflächen zwischen Deckel und Unterteil und dient zur Abdichtung des Innenraumes, welcher von dem Unterteil und dem Deckel umschlossen wird, nach außen hin. Ein Elastomer-Element, welches als Federelement dient, kann gemeinsam mit einer solchen Dichtung leicht im Spritzguss direkt an der Abdeckung ausgebildet werden, sodass eine kostengünstige und einfache Fertigung möglich ist.

Das Bedienfeld ist vorzugsweise an einer Außenseite des Deckels angeordnet und der Deckel weist unterhalb des Bedienfeldes zumindest eine Öffnung auf, sodass Anzeigelemente unterhalb des Deckels, d. h. Anzeigelemente, welche an der Elektronikeinheit gelegen sind, durch das Bedienfeld und den Deckel hindurch von außen sichtbar sind. Auch verformbare Druckbereiche können so durch die Öffnung im Deckel hindurch auf elektrische Schaltelemente an der Elektronikeinheit wirken. Das Bedienfeld ist bevorzugt an der Außenseite des Deckels durch eine Klebverbindung befestigt. Gleichzeitig wird so eine dichte Verbindung geschaffen, sodass die Öffnung in dem Deckel nach außen abgedichtet ist.

Dabei weist das Bedienfeld weiter bevorzugt an seiner der Elektronikeinheit abgewandten Oberfläche eine geschlossene Deckfolie auf. Dies führt zum einen zu einem optisch ansprechenden Erscheinungsbild des Bedienfeldes. Darüber hinaus ist das Bedienfeld von außen leicht zu reinigen, weil so eine glatte Oberfläche ausgebildet wird. Darüber hinaus gibt es in dem Bedienfeld keine Öffnungen oder Spalte, in welche Verunreinigungen oder beispielsweise Feuchtigkeit eindringen könnte.

Besonders bevorzugt wird ein Elektromotor gemäß der vorangehenden Beschreibung als elektrischer Antriebsmotor in einem Pumpenaggregat, beispielsweise einem ein- oder mehrstufigen Kreiselpumpenaggregat eingesetzt. Ein solches Pumpenaggregat mit einem solchen Elektromotor, wie er vorangehend beschrieben wurde, ist entsprechend ebenfalls Gegenstand der Erfindung.

Nachfolgend wird die Erfindung beispielhaft anhand der beigefügten Figuren beschrieben. In diesen zeigt:
- Fig. 1: eine perspektivische Gesamtansicht eines erfindungsgemäßen Elektromotors,
- Fig. 2: eine Ansicht gemäß Fig. 1, bei welcher der Deckel in einer um 180° gedrehten Ausrichtung an dem Elektronikgehäuse befestigt ist,
- Fig. 3: eine Explosionsansicht des Elektromotors gemäß Fig. 1 und 2,
- Fig. 4: eine geöffnete perspektivische Ansicht des Elektronikgehäuses,
- Fig. 5: eine Ansicht des Elektronikgehäuses gemäß Fig. 4 mit gelöster Elektronikeinheit,
- Fig. 6: eine Schnittansicht durch das geöffnete Elektronikgehäuse und
- Fig. 7: eine Ansicht des Details VII in Fig. 6.

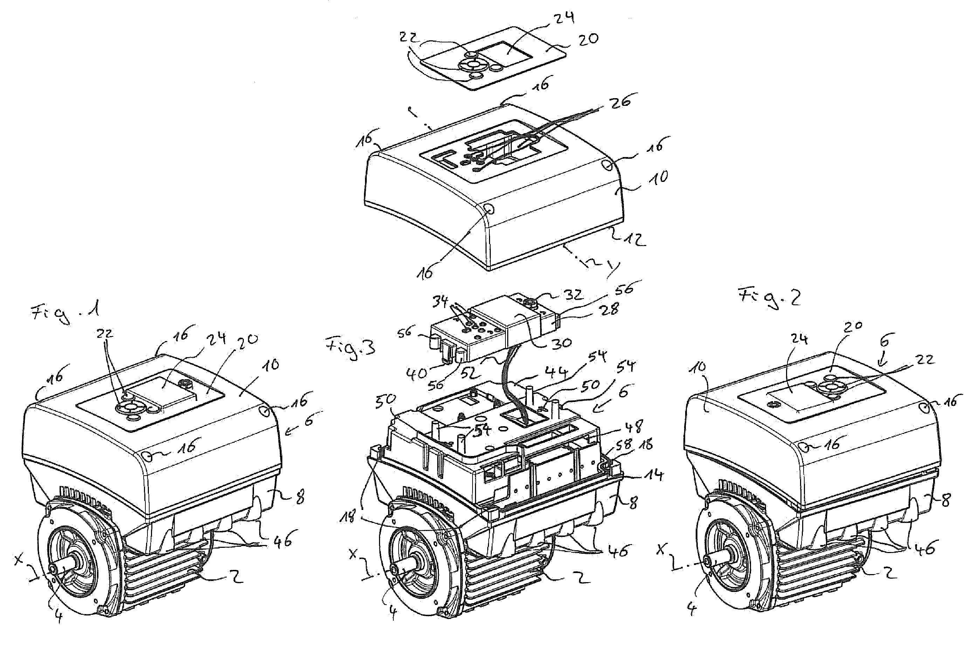

Der erfindungsgemäße Elektromotor weist ein Statorgehäuse auf, in welchem in bekannter Weise Stator und Rotor des Elektromotors angeordnet sind. Aus dem Statorgehäuse 2 erstreckt sich eine Rotorwelle 4 an einer Axialseite nach außen. Bezogen auf die Drehachse X des Elektromotors ist radialseitig an dem Statorgehäuse 2 an dessen Außenumfang ein Elektronikgehäuse 6 angeordnet. Das Elektronikgehäuse 6 besteht aus einem Unterteil 8, welches mit dem Statorgehäuse 2 verbunden, insbesondere verschraubt ist, und einem Deckel 10, welcher das Unterteil 8 an seiner dem Statorgehäus 2 abgewandten Seite abdeckt bzw. verschließt. Dazu kommt der Deckel 10 mit seiner Umfangskante 12, 14 an einer Umfangskante bzw. Stirnkante 14 des Unterteils 18 in Anlage. Befestigt wird der Deckel 10 an dem Unterteil 8 über vier Schrauben, welche in die Schraublöcher 16 des Deckels 10 eingreifen und durch diese hindurch in Gewindelöcher 18 in dem Unterteil 8 eingreifen. Der Deckel 10 ist im Bereich seiner Umfangskante 12 und in der Anordnung der Schraublöcher 16 spiegelsymmetrisch zu der Achse Y ausgebildet. Dies ermöglicht es, den Deckel 10 in zwei um 180° zueinander gedrehten Anordnungen an dem Unterteil 8 zu befestigen, wie in den Figuren 1 und 2 gezeigt ist. In der Fig. 1 ist der Deckel 10 in einer ersten Ausrichtung und in der Fig. 2 in einer zweiten, um 180° gedrehten Ausrichtung an dem Unterteil 8 befestigt.

Der Deckel 10 trägt an seiner dem Unterteil 8 abgewandten Oberseite ein Bedienfeld 20 einer Bedieneinheit. Das Bedienfeld 20 ist als ein Folienelement aus Kunststoff ausgebildet und mit dem Deckel 10 verklebt, sodass es mit dem Deckel 10 fest verbunden ist. Wie in den Figuren 1 und 2 zu erkennen ist, wird das Bedienfeld 20 gemeinsam mit dem Deckel 10 unterschiedlich ausgerichtet, je nach dem in welcher Winkellage der Deckel 10 an dem Unterteil 8 befestigt wird. So ist zu erkennen, dass in Fig. 1 die Bedienelemente in Form von Druckbereichen 22 in der Abbildung links gelegen sind, während dieselben Bedienelemente in Form der Druckbereiche 22 in der Ausrichtung gemäß Fig. 2 in der Ansicht rechts gelegen sind. Neben den Druckbereichen 22 weist das Bedienfeld 20 ein Fenster 24 auf, welches transparent ausgebildet ist. Unter dem Fenster 24 und den Druckbereichen 22 des Bedienfeldes 20 sind in dem Deckel 10 Öffnungen bzw. Ausnehmungen 26 ausgebildet. Die Öffnungen 26 werden durch das Bedienfeld 20, welches an der Außenseite des Deckels 10 befestigt ist, überdacht und dicht verschlossen. Das Bedienfeld 20 stellt ein rein mechanisches Bauteil ohne elektrische Elemente dar und kann mit dem Deckel 10 vollständig von dem Unterteil 8 abgenommen werden. Unterhalb des Deckels 10 und dort unterhalb des Bedienfeldes 20 ist im Inneren des Elektronikgehäuses, eine Elektronikeinheit 28 angeordnet, welche gemeinsam mit dem Bedienfeld 20 die Bedieneinheit bildet. Die Elektronikeinheit 28 trägt ein Display 30, LED 32 und elektrische Schaltelemente 34 in Form von Tastern. Die Schaltelemente 34 liegen dabei unterhalb der Druckbereiche 22 des Bedienfeldes 20 sodass bei Druck auf die Druckbereiche 22 sich diese in Richtung der Elektronikeinheit 28 verformen können und auf die Schaltelemente 34 drücken können. Das Display 30 liegt unter dem Fenster 24 und die LED 32 liegen unter einem transparenten weiteren Bereich des Bedienfeldes 20, sodass sie durch das Bedienfeld 20 hindurch leuchten können.

Die Elektronikeinheit 28 weist in ihrem Inneren eine Leiterplatte 36 auf, an welcher das Display 30 die Schaltelemente 34 und die LED 23 angeordnet sind und elektronische Bauteile der Bedieneinheit angedacht sind. Die Leiterplatte 36 ist unter einer Abdeckung bzw. in einem Gehäuse 38 angeordnet und in diesem Gehäuse 38 befestigt. Das Gehäuse 38 ist vorzugsweise volltransparent ausgebildet und überdeckt das Display 30 und die LED 32 und weist Öffnungen auf, durch welche sich die Schaltelemente 34 nach außen zum Bedienfeld 20 hin erstrecken. Das Gehäuse 38 weist darüber hinaus Rastelemente in Form von Rasthaken 40 auf, mit denen die Elektronikeinheit 28 in dem Unterteil 8 befestigt ist.

In dem Unterteil 8 ist eine Leiterplatte 42 angeordnet, welche elektronische Bauteile, insbesondere elektronische Bauteile eines Frequenzumrichters trägt. Zum Schutz dieser Leiterplatte 42 und der elektronischen Bauteile ist die Leiterplatte 42 von einer Abdeckung 44 überdeckt. Die Abdeckung 44 dient insbesondere dazu, die Leiterplatte 42 und die elektronischen Bauteile zu schützen, wenn der Deckel 10 abgenommen ist. Der Deckel 10 wird insbesondere dann abgenommen, wenn elektrische Anschlussleitungen, welche durch die Kabeldurchführungen 46 in das Innere des Elektronikgehäuses 6 geführt werden, an entsprechenden Anschlusselementen an der Leiterplatte 42 anzuschließen. Die Abdeckung 44 weist Öffnungen 48 auf, durch welche entsprechende Anschlussleitungen an hier nicht näher gezeigten Anschlusselementen an der Leiterplatte 42 angeschlossen werden können.

Die Elektronikeinheit 28 wird mit den Rasthaken 40 in Rastausnehmungen 50 an der Abdeckung 44 fixiert. Dabei sind Rastausnehmungen 50 vorgesehen, welche ebenfalls bezüglich der Symmetrieachse Y spiegelsymmetrisch angeordnet sind. Dies ermöglicht es, auch die Elektronikeinheit 28 in zwei um 180° gedrehten Ausrichtungen an der Abdeckung 44 zu befestigen. So kann die Elektronikeinheit 28 passend zu der Ausrichtung des Deckels 10 an der Abdeckung 44 fixiert werden, sodass das Display 30 stets unter dem Fenster 24 und die Schaltelemente 34 unter den Druckbereichen 26 des Bedienfeldes 20 gelegen sind. Die elektrische Verbindung zwischen der Leiterplatte 36 und der Leiterplatte 42 wird dabei durch eine Kabelverbindung 52 hergestellt, welche eine Drehung der Elektronikeinheit 28 um 180° relativ zu der Abdeckung 44 und der unter dieser angeordneten Leiterplatte 42 zulässt.

Um die Elektronikeinheit 28 in Anlage an der Innenseite des Deckels 10 und insbesondere die Schaltelemente 34 in Anlage mit den Druckbereichen 22 des Bedienfeldes 20 zu halten, sind Federelemente in Form von Elastomer-Elementen 54 vorgesehen. Die Elastomer-Elemente 54 erstrecken sich säulenförmig von der Abdeckung 4 nach außen weg und sind parallel zueinander ausgerichtet. Dabei sind vier Elastomer-Elemente 54 vorgesehen, von denen jeweils zwei symmetrisch zu der Symmetrieachse Y angeordnet sind. Die Elastomer-Elemente 54 greifen in die Aufnahme 56 an dem Gehäuse 38 der Elektronikeinheit 28 ein. Dabei sind die Aufnahmen 58 zu der Abdeckung 44 hin geöffnet. Es sind ebenfalls vier Aufnahmen 56 vorgesehen, von denen ebenfalls jeweils zwei spiegelsymmetrisch zu der Symmetrieachse Y angeordnet sind. Dies ermöglicht es, dass die Elektronikeinheit 28 mit ihrem Gehäuse 38 alternativ in zwei um 180° zueinander verdrehten Winkelpositionen auf die Elastomer- Elemente 54 aufsetzbar ist.

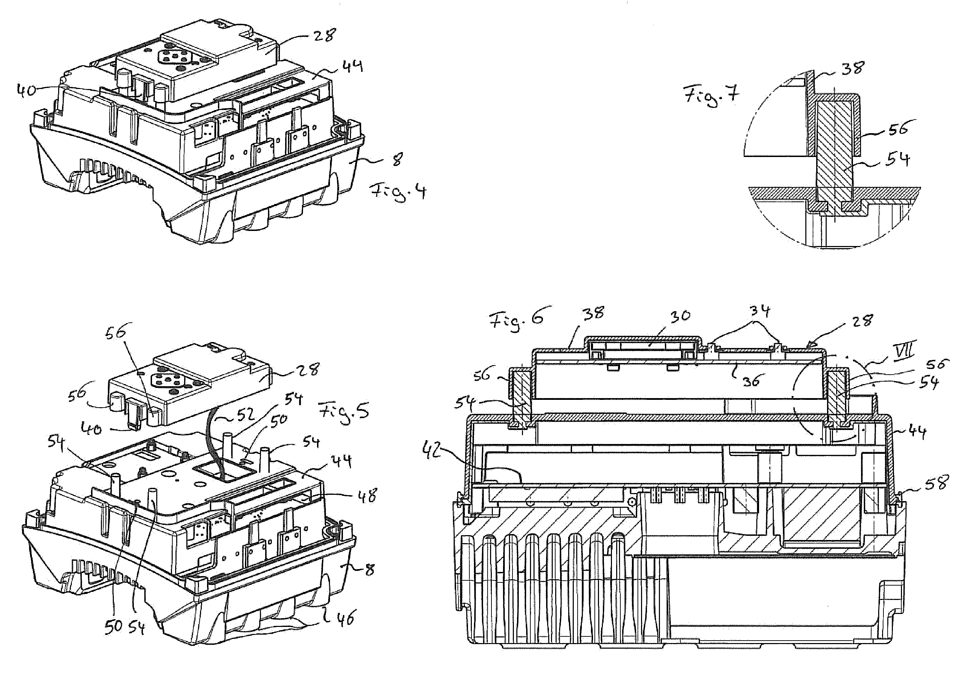

Die Rastverbindung zwischen den Rasthaken 4 und den Rastausnehmungen 50 ist mit Spiel ausgebildet, sodass die Elastomer-Elemente 54, wenn die Rasthaken 40 in die Rastausnehmungen 50 eingreifen, gestaucht werden. Darüber hinaus ist in der Rastverbindung so viel Spiel vorgesehen, dass auch nach Eingriff der Rasthaken 40 in die Rastausnehmungen 50 die Elektronikeinheit 28 durch Druck weiter auf die Abdeckung 44 zu bewegt werden kann. Zunächst wird die Elektronikeinheit 28 wie in Fig. 4 gezeigt, über die Rastverbindung an der Abdeckung 44 fixiert. Anschließend wird der Deckel in der zu der gewählten Ausrichtung der Elektronikeinheit 28 korrespondieren Ausrichtung bzw. Winkellage auf das Unterteil 8 aufgesetzt. Dabei kommt die Innenseite des Deckels 10 mit der Oberseite der Elektronikeinheit 28 bzw. deren Gehäuse 38 in Kontakt und drückt die Elektronikeinheit 28 durch weitere Stauchung der Elastomer-Elemente 54 gegen die Federkraft der Elastomer-Elemente 54 weiter zu der Abdeckung 44 hin. Auf diese Weise wird eine sichere Anlage der Elektronikeinheit 28 an der Innen- bzw. Unterseite des Bedienfeldes 20 bzw. der Innenseite des Deckels 10 im Bereich des Bedienfeldes 20 sichergestellt.

Die Elastomer-Elemente 54 sind an die Abdeckung 44 angeformt und einstückig mit einer Dichtung 58 am Außenumfang der Abdeckung 44 ausgebildet. Die Dichtung 58 kommt zwischen dem Unterteil 8 und dem Deckel 10 im Bereich deren Umfangskanten 12 und 14 zur Anlage und dichtet den Spalt zwischen Deckel 10 und Unterteil 8 nach außen ab. Die Dichtung 58 kann somit gemeinsam mit den Elastomer-Elementen 54 durch Spritzgießen an der Abdeckung 44 ausgebildet werden.

### Bezugszeichenliste

- 2: Statorgehäuse
- 4: Rotorwelle
- 6: Elektronikgehäuse
- 8: Unterteil
- 10: Deckel
- 12, 14: Umfangskanten
- 16: Schraublöcher
- 18: Gewindelöcher
- 20: Bedienfeld
- 22: Druckbereiche
- 24: Fenster
- 26: Öffnungen
- 28: Elektronikeinheit
- 30: Display
- 32: LED
- 34: Schaltelemente
- 36: Leiterplatte
- 38: Gehäuse
- 40: Rasthaken
- 42: Leiterplatte
- 44: Abdeckung
- 46: Kabeldurchführungen
- 48: Öffnungen
- 50: Rastausnehmungen
- 52: Kabelverbindung
- 54: Elastomer-Elemente
- 56: Aufnahmen
- 58: Dichtung
- X: Drehachse
- Y: Symmetrieachse

## Patentansprüche

1. Elektromotor mit einem Elektronikgehäuse (6), welches einen abnehmbaren Deckel (10) sowie eine Bedieneinheit aufweist, wobei die Bedieneinheit ein an dem Deckel (10) befestigtes Bedienfeld (20) aufweist, **dadurch gekennzeichnet, dass** der Deckel (10) mit dem Bedienfeld (20) in zumindest zwei alternativen Ausrichtungen mit einem Unterteil (8) des Elektronikgehäuses (6) verbindbar ist.

2. Elektromotor nach Anspruch 1, **dadurch gekennzeichnet, dass** mit dem Unterteil (8) in Kontakt kommende Schnittstellen (12) des Deckels (10) spiegelsymmetrisch zu einer Mittellinie (Y) des Deckels (10) ausgebildet sind.

3. Elektromotor nach Anspruch 1 oder 2, **dadurch gekennzeichnet, dass** die Bedieneinheit neben dem Bedienfeld (20) eine in dem Unterteil (8) getrennt von dem Deckel (10) angeordnete Elektronikeinheit (28) aufweist, welche mit dem Bedienfeld (20) zusammenwirkt.

4. Elektromotor nach Anspruch 3, **dadurch gekennzeichnet, dass** das Bedienfeld (20) ein rein mechanisches Bauteil ist, welche frei von elektrischen Bauteilen ist.

5. Elektromotor nach Anspruch 3 oder 4, **dadurch gekennzeichnet, dass** die Elektronikeinheit (28) in dem Unterteil (8) in zumindest zwei zu den alternativen Ausrichtungen des Deckels (10) korrespondierenden Ausrichtungen befestigbar ist.

6. Elektromotor nach einem der Ansprüche 3 bis 5, **dadurch gekennzeichnet, dass** die Elektronikeinheit (28) über zumindest ein Rastelement (40) in dem Unterteil (8) fixiert ist.

7. Elektromotor nach Anspruch 3 bis 6, **dadurch gekennzeichnet, dass** das Bedienfeld (20) mit zumindest einem transparenten Fenster (24) und die Elektronikeinheit (28) mit zumindest einem unter diesem Fenster (24) platzierten Anzeigeelement (34) versehen ist.

8. Elektromotor nach einem der Ansprüche 3 bis 7, **dadurch gekennzeichnet, dass** das Bedienfeld (28) mit zumindest einem elastisch verformbaren Druckbereich (22) versehen ist und die Elektronikeinheit (28) zumindest ein unter diesem Druckbereich (22) platziertes elektrisches Schaltelement (34) aufweist.

9. Elektromotor nach einem der Ansprüche 3 bis 8, **dadurch gekennzeichnet, dass** die Elektronikeinheit (28) über zumindest eine Steck- und/oder Kabelverbindung (52) elektrisch mit weiteren in dem Unterteil (8) angeordneten elektronischen Bauteilen (42) verbunden ist.

10. Elektromotor nach einem der Ansprüche 3 bis 9, **dadurch gekennzeichnet, dass** die Elektronikeinheit (28) über zumindest ein Federelement (54) in Anlage an dem Bedienfeld (20) und/oder in Anlage an einer Innenseite des Deckels (10) gehalten wird.

11. Elektromotor nach Anspruch 10, **dadurch gekennzeichnet, dass** das zumindest eine Federelement (54) an einer Abdeckung (44) befestigt ist, welche im Inneren des Elektronikgehäuses (6) angeordnet ist und im Unterteil (8) angeordnete elektronische Bauteile (42) zum Deckel (10) hin abdeckt.

12. Elektromotor nach Anspruch 10 oder 11, **dadurch gekennzeichnet, dass** das zumindest eine Federelement (54) ein Elastomer-Element ist.

13. Elektromotor nach Anspruch 11 und 12, **dadurch gekennzeichnet, dass** das Elastomer-Element (54) einstückig mit einer an der Abdeckung (44) angeordneten Dichtung (58) ausgebildet ist, welche vorzugsweise dichtend mit dem Unterteil (8) und dem Deckel (10) in Anlage ist.

14. Elektromotor nach einem der Ansprüche 3 bis 13, **dadurch gekennzeichnet, dass** das Bedienfeld (20) an einer Außenseite des Deckels (10) angeordnet ist und der Deckel (10) unterhalb des Bedienfeldes zumindest eine Öffnung (26) aufweist.

15. Elektromotor nach einem der Ansprüche 3 bis 14, **dadurch gekennzeichnet, dass** das Bedienfeld (20) an seiner der Elektronikeinheit (28) abgewandten Oberfläche eine geschlossene Deckfolie aufweist.

16. Pumpenaggregat mit einem elektrischen Antriebsmotor, **dadurch gekennzeichnet, dass** der elektrische Antriebsmotor ein Elektromotor gemäß einem der vorangehenden Ansprüche ist.

## Claims

1. An electric motor with an electronics housing (6) which comprises a removable cover (10) as well as an operating unit,
wherein
the operating unit comprises an operating panel (20) fastened on the cover (10), **characterised in that** the cover (10) with the operating panel (20) is connectable to a lower part (8) of the electronics housing (6) in at least two alternative alignments.

2. An electric motor according to claim 1, **characterised in that** interfaces (12) of the cover (10) which come into contact with the lower part (8) are formed mirror-symmetrically to a middle line (Y) of the cover (10).

3. An electric motor according to claim 1 or 2, **characterised in that** the operating unit apart from the operating panel (20) comprises an electronics unit (28) which is arranged in the lower part (8) in a manner separated from the cover (10) and which cooperates with the operating panel (20).

4. An electric motor according to claim 3, **characterised in that** the operating panel (20) is a purely mechanical component which is free of electric components.

5. An electric motor according to claim 3 or 4, **characterised in that** the electronics unit (28) can be fastened in the lower part (8) in at least two alignments corresponding to the alternative alignments of the cover (10).

6. An electric motor according to one of the claims 3 to 5, **characterised in that** the electronics unit (28) is fixed in the lower part (8) via at least one detent element (40).

7. An electric motor according to claim 3 to 6, **characterised in that** the operating panel (20) is provided with at least one transparent window (24), and the electronics unit (28) is provided with at least one display element (34) which is placed below this window (24).

8. An electric motor according to one of the claims 3 to 7, **characterised in that** the operating panel (28) is provided with at least one elastically deformable push region (22), and the electronics unit (28) comprises at least one electrical switch element (34) which is placed below this push region (22).

9. An electric motor according to one of the claims 3 to 8, **characterised in that** the electronics unit (28) is electrically connected via at least one plug-in connection and/or cable connection (52) to further electronic components (42) arranged in the lower part (8).

10. An electric motor according to one of the claims 3 to 9, **characterised in that** the electronics unit (28) via at least one spring element (54) is held in contact on the operating panel (20) and/or in contact on the inner side of the cover (10).

11. An electric motor according to claim 10, **characterised in that** the at least one spring element (54) is fastened on a covering (44) which is arranged in the inside of the electronics housing (6) and covers electronic components (42) arranged in the lower part (8) to the cover (10).

12. An electric motor according to claim 10 or 11, **characterised in that** the at least one spring element (54) is an elastomer element.

13. An electric motor according to claim 11 and 12, **characterised in that** the elastomer element (54) is designed as one piece with a seal (58) which is arranged on the covering (44) and which is preferably in sealingly contact with the lower part (8) and the cover (10).

14. An electric motor according to one of the claims 3 to 13, **characterised in that** the operating panel (20) is arranged on an outer side of the cover (10), and the cover (10) below the operating panel comprises at least one opening (26).

15. An electric motor according to one of the claims 3 to 14, **characterised in that** the operating panel (20) on its surface which is away from the electronics unit (28) comprises a closed cover film.

16. A pump assembly with an electric drive motor, **characterised in that** the electric drive motor is an electric motor according to one of the preceding claims.

## Revendications

1. Moteur électrique comprenant un boîtier d'électronique (6) qui comporte un couvercle amovible (10) ainsi qu'une unité de commande, dans lequel l'unité de commande comporte un tableau de commande (20) fixé au couvercle (10), **caractérisé en ce que** le couvercle (10), avec le tableau de commande (20), peut être assemblé à une partie inférieure (8) du boîtier d'électronique (6) dans au moins deux orientations différentes.

2. Moteur électrique selon la revendication 1, **caractérisé en ce que** des zones d'interface (12) du couvercle (10) qui entrent en contact avec la partie inférieure (8) sont symétriques en miroir par rapport à une ligne médiane (Y) du couvercle (10).

3. Moteur électrique selon la revendication 1 ou 2, **caractérisé en ce que** l'unité de commande comporte à côté du tableau de commande (20) une unité électronique (28) logée dans la partie inférieure (8) séparément du couvercle (10) et qui coopère avec le tableau de commande (20).

4. Moteur électrique selon la revendication 3, **caractérisé en ce que** le tableau de commande (20) est un composant purement mécanique dépourvu de composants électriques.

5. Moteur électrique selon la revendication 3 ou 4, **caractérisé en ce que** l'unité électronique (28) peut être fixée dans la partie inférieure (8) dans au moins deux orientations qui correspondent aux différentes orientations du couvercle (10).

6. Moteur électrique selon l'une des revendications 3 à 5, **caractérisé en ce que** l'unité électronique (28) est fixée dans la partie inférieure (8) au moyen d'au moins un élément à encliquetage (40).

7. Moteur électrique selon l'une des revendications 3 à 6, **caractérisé en ce que** le tableau de commande (20) est muni d'au moins une fenêtre transparente (24) et que l'unité électronique (28) comporte au moins un élément d'affichage (34) placé sous cette fenêtre (24).

8. Moteur électrique selon l'une des revendications 3 à 7, **caractérisé en ce que** le tableau de commande (28) est muni d'au moins une zone de pression élastiquement déformable (22) et l'unité électronique (28) comporte au moins un élément de commutation électrique (34) placé sous cette zone de pression (22).

9. Moteur électrique selon l'une des revendications 3 à 8, **caractérisé en ce que** l'unité électronique (28) est reliée électriquement à d'autres composants électroniques (42) disposés dans la partie inférieure (8) au moyen d'au moins une connexion par fiche et/ou câble (52).

10. Moteur électrique selon l'une des revendications 3 à 9, **caractérisé en ce que** l'unité électronique (28) est maintenue en appui contre le tableau de commande (20) et/ou en appui contre un côté intérieur du couvercle (10) au moyen d'au moins un élément élastique (54).

11. Moteur électrique selon la revendication 10, **caractérisé en ce que** ledit élément élastique (54), au moins au nombre de un, est fixé à un chapeau (44) qui est disposé à l'intérieur du boîtier d'électronique (6) et recouvre jusqu'au couvercle (10) des composants électroniques (42) logés dans la partie inférieure (8).

12. Moteur électrique selon la revendication 10 ou 11, **caractérisé en ce que** ledit élément élastique (54), au moins au nombre de un, est un élément en élastomère.

13. Moteur électrique selon la revendication 11 ou 12, **caractérisé en ce que** l'élément en élastomère (54) est formé en une seule pièce avec une garniture d'étanchéité (58) solidaire du chapeau (44) et qui est en contact de préférence à joint étanche avec la partie inférieure (8) et avec le couvercle (10).

14. Moteur électrique selon l'une des revendications 3 à 13, **caractérisé en ce que** le tableau de commande (20) est disposé sur un côté extérieur du couvercle (10) et que le couvercle (10) comporte au moins une ouverture (26) au-dessous du tableau de commande.

15. Moteur électrique selon l'une des revendications 3 à 14, **caractérisé en ce que** le tableau de commande (20) comporte une feuille de recouvrement fermée au niveau de la surface de celle-ci distante de l'unité électronique (28).

16. Groupe pompe équipé d'un moteur d'entraînement électrique, **caractérisé en ce que** le moteur d'entraînement électrique est constitué par un moteur électrique selon l'une des revendications précédentes.
